# FASCICULE DE BREVET EUROPEEN

(11) **EP 0 738 787 B1**
(45) Date de publication et mention de la délivrance du brevet: **22.07.1998**
(21) Numéro de dépôt: 96400781.9
(22) Date de dépôt: 11.04.1996
(51) Int. Cl.: C23C 16/02, C23C 30/00

(54) **Procédé de fabrication d'une pièce métallique recouverte de diamant**
Verfahren zur Herstellung eines diamantbeschichteten Metallkörpers
Method of making a metal object covered with diamond

(30) Priorité: 21.04.1995 FR 9504788
(43) Date de publication de la demande: 23.10.1996
(73) Titulaire: ETAT FRANCAIS Représenté par le Délégué Général pour l'Armement, 75007 Paris 7ème (FR)
(72) Inventeur: Farges, Guy, 91620 La Ville du Bois (FR); Vandenbulcke, Lionel, 45650 Saint Jean le Blanc (FR); Rats, David, 22400 Andel (FR)

(56) Documents cités:
- EP-A- 0 514 032
- DE-A- 3 522 583
- US-A- 5 308 661
- PATENT ABSTRACTS OF JAPAN vol. 010, no. 287 (C-375), 30 Septembre 1986 & JP-A-61 104078 (TOSHIBA TUNGALOY CO LTD), 22 Mai 1986,
- PATENT ABSTRACTS OF JAPAN vol. 017, no. 037 (C-1019), 25 Janvier 1993 & JP-A-04 254584 (SEIKO INSTR INC), 9 Septembre 1992,
- JOURNAL OF APPLIED PHYSICS, 15 AUG. 1994, USA, vol. 76, no. 4, ISSN 0021-8979, pages 2164-2168, XP000466361 WEISER P S ET AL: "Chemically vapor deposited diamond films grown on titanium nitride coated and uncoated iron substrates"
- JOURNAL OF MATERIALS SCIENCE, 15 DEC. 1992, UK, vol. 27, no. 24, ISSN 0022-2461, pages 6735-6742, XP000574096 PIVIN J C: "Tribology of amorphous diamond films grown or modified by ion implantation"
- PATENT ABSTRACTS OF JAPAN vol. 014, no. 522 (C-0778), 15 Novembre 1990 & JP-A-02 217472 (IDEMITSU PETROCHEM CO LTD), 30 Août 1990,
- PATENT ABSTRACTS OF JAPAN vol. 011, no. 218 (M-607), 15 Juillet 1987 & JP-A-62 034704 (SHOWA DENKO KK), 14 Février 1987,
- PATENT ABSTRACTS OF JAPAN vol. 012, no. 105 (M-681), 6 Avril 1988 & JP-A-62 236630 (YASUNOBU AKIMOTO), 16 Octobre 1987,
- PATENT ABSTRACTS OF JAPAN vol. 013, no. 504 (C-653), 13 Novembre 1989 & JP-A-01 201480 (SUMITOMO ELECTRIC IND LTD), 14 Août 1989,

## Description

La présente invention est relative à un procédé de fabrication d'une pièce métallique revêtue d'une couche de diamant polycristallin ainsi qu'à une pièce métallique obtenue au moyen d'un tel procédé de fabrication.

L'invention se rapporte en particulier à un procédé de fabrication d'une pièce en titane ou en alliage de titane revêtue d'une couche de diamant polycristallin ainsi qu'à une pièce en titane obtenue au moyen de ce procédé de fabrication.

Les pièces en titane ou en alliage de titane désignent des pièces métalliques dont le constituant principal est le titane allié ou non à d'autres éléments en plus faible concentration.

Un alliage très couramment utilisé pour fabriquer de telles pièces est l'alliage connu sous l'appellation alliage "TA6V".

Il est connu que les alliages de titane, et en particulier l'alliage TA6V, présentent de bonnes caractéristiques mécaniques, notamment une bonne résistance à la traction, à la fatigue, à la corrosion et une bonne tenue au fluage, et une masse volumique relativement faible. Ces alliages sont donc largement utilisés dans les domaines aéronautique et spatial.

Par ailleurs, il est connu que le titane présente une très bonne immunité biologique et est donc largement utilisé dans le domaine biomédical.

Toutefois, les alliages de titane ont une mauvaise résistance à l'usure, en particulier lorsqu'ils sont en contact avec un métal ou un alliage métallique et un coefficient de frottement élevé avec un grand nombre de matériaux.

Les alliages de titane peuvent présenter en outre une certaine toxicité en raison de la présence d'autres éléments d'alliage.

Pour pallier ces inconvénients, on dépose par exemple sur les alliages de titane une couche de carbone, par exemple sous forme d'une couche de diamant polycristallin, permettant, en fonction de l'utilisation de l'alliage, d'augmenter la résistance à l'usure et d'améliorer l'immunité biologique.

Actuellement, le dépôt d'une couche de diamant polycristallin sur une pièce métallique est effectué à température élevée, dans la gamme allant de 800 à 850°C, ce qui provoque, lors du retour à la température ambiante, l'apparition de contraintes résiduelles très importantes dans la couche de diamant, de l'ordre de 7 GPa. Les techniques actuelles de revêtement d'une pièce par une couche de diamant ne permettent donc pas de déposer des couches de diamant d'épaisseur supérieure à 1 µm (1 micron) sans que celles-ci ne s'écaillent lors du refroidissement.

Par ailleurs, le dépôt de diamant à température élevée provoque une diffusion relativement importante de carbone dans le substrat métallique, ce qui provoque une modification à coeur des propriétés mécaniques intrinsèques du substrat métallique.

On a tenté de pallier ces inconvénients en effectuant un dépôt d'une couche de diamant polycristallin sur un substrat métallique à température plus faible, par exemple inférieure à environ 700°C. Un dépôt à une telle température permet d'obtenir une couche d'épaisseur plus importante, cependant l'adhérence du diamant sur le métal est relativement médiocre.

Le brevet DE - A-35 22 583 concerne des substrats métalliques, en céramique, en alliage de métaux, sur lesquels on dépose une couche de diamant d'épaisseur environ 2 µm (microns) par traitement du substrat au filament de tantale chaud. Il se forme au cours du procédé une ou plusieurs couche(s) intermédiaire(s) dont la dernière est une couche d'accrochage pour le diamant, et qui sont constituées de combinaisons résistantes à la chaleur telles borures, carbures, nitrures, et oxydes des éléments des groupes 3a, 4a (Titane), 4b à 6b de la classification périodique.

Le brevet EP -A-0 514 032 concerne aussi un substrat dur à base de carbure cémenté, de céramique frittée, de matériaux céramique mais aussi d'acier, sur lequel on dépose une couche de carbure ou nitrure d'un métal des groupes Vb et VIb, Va (Vanadium) VIa avant dépôt d'une couche de diamant d'épaisseur environ 6 µm (microns).

La présente invention vise à pallier les inconvénients cités en proposant un procédé de fabrication d'une pièce métallique revêtue d'une couche de diamant polycristallin d'épaisseur relativement importante dans laquelle les contraintes résiduelles à température ambiante sont inférieures à environ 6 GPa et n'entraînent pas de modification des propriétés mécaniques de la pièce métallique. Elle a donc pour objet un procédé de fabrication d'une pièce métallique revêtue d'une couche de diamant polycristallin, caractérisé en ce qu'il comporte les étapes consistant à :
- fabriquer un substrat métallique comprenant une surface à revêtir dont le constituant principal est le titane;
- déposer dans une première étape sur la surface à revêtir une couche de carbone d'accrochage du diamant comportant au moins 10 % de carbone graphitique ou amorphe et destinée à diffuser entièrement dans le titane pendant une deuxième étape ; et
- déposer dans la deuxième étape sur la couche d'accrochage le revêtement de diamant.

Le procédé selon l'invention peut en outre comporter une ou plusieurs des caractéristiques suivantes :
- au cours de l'étape de fabrication du substrat métallique, on dépose sur une masse métallique une couche à revêtir dont le constituant principal est le titane;
- on dépose sur la masse métallique préalablement au dépôt de la couche à revêtir, une couche réfractaire, destinée à former une barrière pour la diffusion du carbone dans le substrat métallique ;
- la masse métallique est constituée de titane ou d'alliage de titane ;
- la masse métallique est constituée d'acier ou de carbure cémenté ;
- la masse métallique étant constituée de carbure cémenté, elle est revêtue d'une couche de carbure de titane, préalablement au dépôt de la couche réfractaire, en vue d'augmenter l'adhésion de celle-ci sur la masse métallique ;
- la couche réfractaire est constituée d'un matériau choisi parmi le groupe constitué par le nitrure de titane, le nitrure de vanadium, le niobium, le tantale, le tungstène et le molybdène, ou d'un alliage comportant un élément choisi parmi ce groupe ;
- la couche réfractaire étant constituée de nitrure de titane, elle est revêtue d'une deuxième couche d'accrochage comportant de l'azote et du titane avec une concentration en azote décroissante en direction de la couche à revêtir en vue d'augmenter l'adhésion de celle-ci sur la couche réfractaire ;
- les étapes de dépôt de la couche d'accrochage et du revêtement de diamant sont réalisées à une température comprise entre 400°C et 700°C ;
- la masse métallique étant constituée de carbure cémenté, les étapes de dépôt de la couche d'accrochage et du revêtement de diamant sont réalisées à des températures respectivement comprises entre 400°C et 700°C et entre 700°C et 850°C.

D'autres caractéristiques et avantages ressortiront de la description suivante, donnée à titre d'exemple, en regard des dessins annexés sur lesquels :
- la figure 1 représente une vue en coupe d'un dispositif de dépôt d'un revêtement de diamant polycristallin sur un substrat métallique pour la mise en oeuvre du procédé selon l'invention ;
- la figure 2 est une vue schématique en coupe d'une pièce métallique obtenue au moyen d'un premier procédé selon l'invention ;
- la figure 3 est une vue schématique en coupe d'une pièce métallique obtenue au moyen d'un deuxième procédé selon l'invention ;
- la figure 4 est une vue schématique en coupe d'une pièce métallique obtenue au moyen d'un troisième procédé selon l'invention ; et
- la figure 5 est un enregistrement en spectroscopie RAMAN obtenu sur la couche de carbone d'accrochage des pièces métalliques des figures 2 à 4.

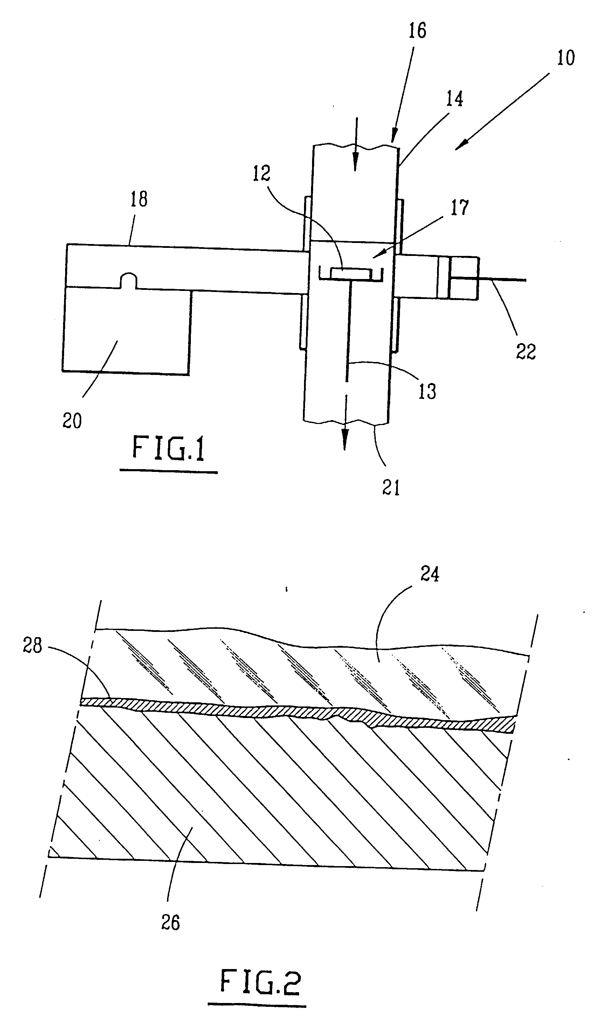

Sur la figure 1, on a représenté un dispositif de dépôt chimique assisté par plasma, connu sous l'appellation dispositif PAVD, et désigné par la référence numérique 10.

Le dispositif PAVD 10 est destiné à déposer une couche de diamant sur une pièce métallique, désignée par la référence numérique 12, disposée sur un support 13.

On entend par pièce métallique une pièce constituée d'un métal, d'un alliage métallique ou d'un composé.

Le dispositif PAVD 10 comporte une enceinte en silice 14 munie d'une ouverture 16 pour l'alimentation en gaz d'une zone de dépôt 17 dans laquelle est produit un plasma par l'intermédiaire d'un guide d'ondes 18 relié à un générateur d'ondes micro-ondes 20.

Les gaz, dont le trajet est illustré par les flèches ressortent par une ouverture 21.

En outre, l'enceinte en silice 14 est reliée de façon connue à une pompe à vide, non représentée.

Par ailleurs, le dispositif PAVD 10 comporte des moyens d'adaptation permettant de limiter la puissance des ondes micro-ondes réfléchies sur la pièce 12 et de régler la position du plasma devant la pièce à revêtir, constitués par un piston 22.

Le dispositif PAVD 10 est complété par des moyens d'adaptation, un système de régulation de débit de gaz, de contrôle et de régulation de la pression, de type connu et non représentés.

La pièce métallique 12 est constituée d'une pièce en alliage de titane de type TA6V.

Le dispositif PAVD 10 permet de déposer sur la pièce métallique 12 éventuellement préalablement décapée par décapage ionique, une couche de diamant polycristallin à des températures comprises entre 400°C et 700°C. Pour ce faire, on dépose sur la surface à revêtir de la pièce d'alliage de titane une couche de carbone d'accrochage pour le diamant comportant au moins 10% de carbone graphitique ou amorphe et destinée à diffuser entièrement dans le titane, et on revêt la couche d'accrochage par du diamant, au cours de la diffusion totale du carbone d'accrochage dans le titane.

A l'issue du dépôt du diamant sur la pièce métallique, une couche fine de carbure de titane est formée sous la couche de diamant, dont l'épaisseur dépend des conditions de dépôt, durée et température.

On voit sur la figure 2 que la pièce métallique ainsi obtenue comporte une couche de diamant polycristallin 24 adhérant à l'alliage TA6V 26 par l'intermédiaire d'une couche de carbure de titane 28.

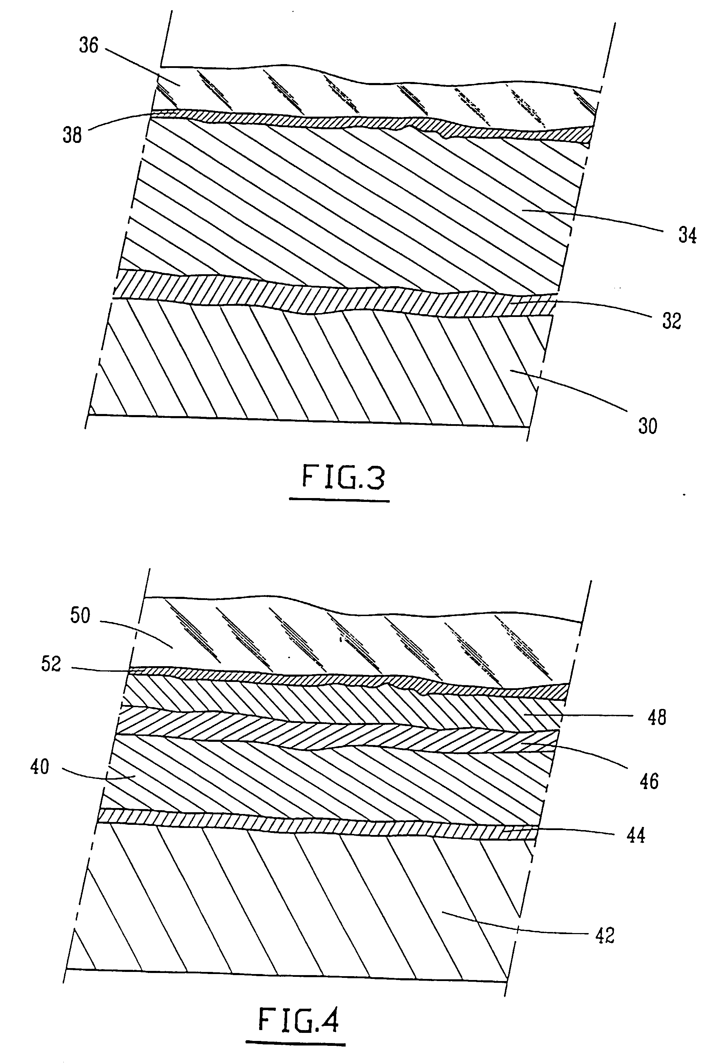

En variante, et comme représenté sur la figure 3, on utilise un substrat métallique constitué d'une masse d'alliage TA6V 30 revêtue d'une couche de matériau réfractaire 32 sur laquelle est déposé un revêtement en titane 34.

Comme précédemment, une couche de diamant polycristallin 36 est ensuite déposée sur la couche à revêtir en titane 34, revêtue préalablement d'une couche de carbone d'accrochage destinée à former une couche de carbure de titane 38.

La couche réfractaire est constituée d'un matériau choisi parmi le groupe constitué par le nitrure de titane, le nitrure de vanadium, le niobium, le tantale, le tungstène et le molybdène, ou d'un alliage comportant un élément choisi parmi ce groupe.

Elle est destinée à former une barrière pour la diffusion du carbone, afin d'éviter que celui-ci ne pénètre dans l'alliage TA6V 30 et donc que les caractéristiques mécaniques à coeur de l'alliage soient modifiées au cours du procédé du dépôt du diamant.

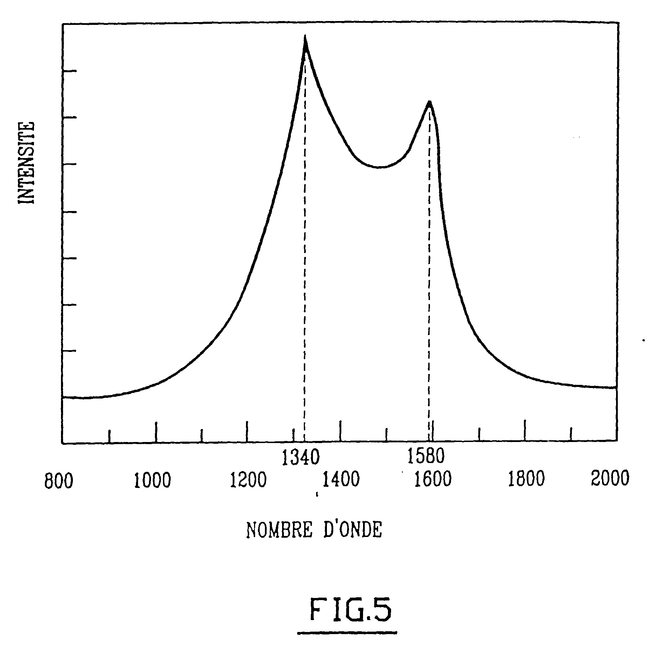

Selon une autre variante, représentée sur la figure 4, dans le cas où la couche réfractaire 40 est constituée de nitrure de titane, cette couche peut être déposée sur l'alliage TA6V 42 avec interposition d'une couche de titane 44 destinée à améliorer l'adhérence de la couche réfractaire 40 sur l'alliage 42.

Une seconde couche d'accrochage contenant de l'azote et du titane 46 destinée à l'accrochage de la couche de titane 48 sur la couche réfractaire 40 en nitrure de titane peut être en outre interposée entre cette couche réfractaire 40 et la couche de titane 48. La seconde couche d'accrochage 46 présente une concentration en azote décroissante de la couche réfractaire 40 en direction de la couche à revêtir 48 afin d'améliorer l'adhésion de cette dernière couche sur la couche réfractaire 40.

Comme dans l'exemple précédent, la couche de titane 48 est ensuite revêtue d'une couche de diamant 50 avec interposition préalable de carbone d'accrochage afin de former une couche de carbure de titane 52.

Dans les différentes variantes du procédé de dépôt d'une couche de diamant polycristallin qui ont été décrites, la pièce métallique est constituée d'alliage de titane de type TA6V.

On peut cependant envisager de déposer au moyen de ce procédé une couche de diamant polycristallin sur une pièce métallique comportant une masse métallique dépourvue de titane, recouverte d'une couche à revêtir comportant du titane ou un alliage de titane, du vanadium ou un alliage de vanadium.

C'est ainsi que la masse métallique peut être constituée d'acier ou de carbure cémenté.

Dans ce dernier cas, la masse métallique étant constituée de carbure cémenté, elle est revêtue d'une couche de carbure de titane à une température comprise entre 400°C et 700°C, préalablement au dépôt de la couche réfractaire en vue d'augmenter l'adhésion de cette couche réfractaire sur la masse métallique. Le dépôt de la couche de diamant peut alors être réalisé à une température comprise entre 700°C et 850°C.

Des exemples de mise en oeuvre du procédé selon l'invention vont maintenant être décrits.

Dans tous ces exemples, la surface sur laquelle on effectue le dépôt de diamant est préparée par un polissage classique puis un polissage par diamant, ce qui permet d'ensemencer la surface à revêtir de la pièce métallique.

### Exemple 1 :

Un dépôt de diamant est réalisé directement sur un alliage de type TA6V au moyen du dispositif représenté sur la figure 1 en deux étapes successives qui peuvent être ou non séparées par un retour à la température ambiante.

Dans une première étape, une couche d'accrochage en carbone dont la proportion de phase graphitique ou amorphe est supérieure à environ 30% est déposée sur une pièce d'alliage TA6V dans les conditions suivantes :
- débit d'hydrogène égal à 200 cm³/mn ;
- débit de méthane égal à 12 cm³/mn ;
- puissance des micro-ondes égale à 400 W;
- pression égale à 0,33kPa (2,5 Torr);
- température égale à 600°C ;
- durée du dépôt égale à 3 heures.

Dans une deuxième étape, on dépose un revêtement de diamant polycristallin sur la pièce métallique revêtue de la couche d'accrochage dans les conditions suivantes:
- débit d'hydrogène égal à 400 cm³/mn ;
- débit de méthane égal à 4 cm³/mn ;
- puissance des micro-ondes égale à 400 W;
- pression égale à 1,33 KPa (10 Torr);
- température égale à 600°C ;
- durée du dépôt égale à 30 heures.

On obtient ainsi une pièce en alliage TA6V, représentée sur la figure 2, dont la structure de l'alliage n'a pas été modifiée, et revêtue d'une couche de diamant ayant une épaisseur de 5 µm (5 microns)

Les contraintes mesurées dans la couche de diamant sont sensiblement de 5 GPa. Ces contraintes plus faibles permettent par conséquent de déposer une couche d'épaisseur supérieure à 1 µm (1micron) sans qu'il se produise un décollement de la couche lors du retour à la température ambiante.

En outre, le coefficient de frottement de cet alliage revêtu de diamant, mesuré dans des conditions classiques après refroidissement est sensiblement inférieur à 0,1.

### Exemple 2 :

Une pièce métallique en alliage TA6V est revêtue d'une couche de diamant polycristallin au moyen du dispositif de la figure 1 selon deux étapes successives séparées ou non par un retour à la température ambiante.

Dans une première étape, une couche d'accrochage en carbone est déposée sur la pièce d'alliage selon les conditions suivantes :
- débit d'hydrogène égal à 200 cm³/mn ;
- débit de méthane égal à 12 cm³/mn ;
- puissance des micro-ondes égale à 400 W;
- pression égale à 0,33 kPa (2,5 Torr);
- température égale à 600°C ;
- durée du dépôt égale à 3 heures.

Dans une deuxième étape, la pièce est revêtue de diamant polycristallin dans les conditions suivantes :
- débit d'hydrogène égal à 180 cm³/mn ;
- débit de monoxyde de carbone égal à 15 cm³/mn ;
- puissance des micro-ondes égale à 400 W;
- pression égale à 1,33 kPa (10 Torr);
- température égale à 600°C ;
- durée du dépôt égale à 25 heures.

La pièce d'alliage TA6V ainsi obtenue est revêtue d'une couche de diamant ayant une épaisseur de 8 µm (8 microns) et ses caractéristiques n'ont sensiblement pas été changées. Par ailleurs, les contraintes mesurées dans la couche diamant après refroidissement sont de 5 GPa environ. Ces contraintes plus faibles permettent de déposer une couche d'épaisseur supérieure à environ 1 µm (micron) sans qu'il se produise un décollement de la couche lors du retour à la température ambiante. Le coefficient de frottement, mesuré de façon classique est inférieur à environ à 0,1.

### Exemple 3 :

Un dépôt de diamant est réalisé sur un alliage TA6V revêtu préalablement par une technique de dépôt physique en phase vapeur (PVD) d'une couche réfractaire en nitrure de titane de 3 µm (3 microns) d'épaisseur, d'une deuxième couche de nitrure de titane, comportant une concentration en azote décroissante en direction de l'extérieur et de 1 µm (1 micron) d'épaisseur, pour augmenter l'adhésion de la couche réfractaire et d'une couche de titane de 3µm (3 microns).

Le dépôt de diamant est effectué au moyen du dispositif de la figure 1 selon deux étapes successives qui peuvent être ou non séparées par un retour à la température ambiante.

Dans une première étape, un dépôt de carbone d'accrochage pour le diamant est effectué dans les conditions suivantes :
- débit d'hydrogène égal à 200 cm³/mn ;
- débit de méthane égal à 12 cm³/mn ;
- puissance des micro-ondes égale à 400 W;
- pression égale à 0,33 kPa (2,5 Torr);
- température égale à 600°C ;
- durée du dépôt égale à 3 heures.

Dans une deuxième étape, un dépôt de diamant est effectué dans les conditions suivantes :
- débit d'hydrogène égal à 180 cm³/mn ;
- débit de monoxyde de carbone égal à 15 cm³/mn ;
- puissance des micro-ondes égale à 400 W;
- pression égale à 1,33 kPa (10 Torr);
- température égale à 600°C ;
- durée du dépôt égale à 7 heures.

On obtient ainsi une pièce en alliage TA6V, dont la structure n'a pas été changée, revêtue d'une part d'une couche réfractaire en nitrure de titane constituant une barrière de diffusion pour le carbone, et d'autre part de sous-couhes intermédiaires dont une couche externe de diamant ayant une épaisseur de 1,5 µm (1,5 micron) adhérant au titane par l'intermédiaire d'une couche de carbure de titane.

Une telle pièce métallique est représentée schématiquement sur la figure 4 décrite précédemment.

Les contraintes mesurées dans la couche de diamant après refroidissement sont sensiblement de 5 GPa et le coefficient de frottement est sensiblement inférieur à 0,1.

### Exemple 4 :

Un dépôt de diamant est réalisé sur un alliage TA6V revêtu préalablement par PVD d'une couche réfractaire en nitrure de titane de 3 µm (3 microns) d'épaisseur, d'une deuxième couche de nitrure de titane destinée à augmenter l'adhésion de la couche réfractaire, comportant un gradient de concentration en azote décroissant en direction de l'extérieur et ayant une épaisseur de 1 µm (micron), et en outre d'une couche de titane de 0,5 µm (0,5 micron) d'épaisseur.

Le dépôt de diamant est effectué au moyen du dispositif de la figure 1 selon deux étapes successives qui peuvent être ou non séparées par un retour à la température ambiante.

Dans une première étape, une couche de carbone d'accrochage pour le diamant est déposée sur la pièce métallique dans les conditions suivantes :
- débit d'hydrogène égal à 200 cm³/mn ;
- débit de méthane égal à 12 cm³/mn ;
- puissance des micro-ondes égale à 400 W;
- pression égale à 0,33 kPa (2,5 Torr);
- température égale à 600°C ;
- durée du dépôt égale à 3 heures.

Dans une deuxième étape, l'alliage est revêtu d'une couche de diamant polycristallin dans les conditions suivantes :
- débit d'hydrogène égal à 180 cm³/mn ;
- débit de monoxyde de carbone égal à 15 cm³/mn ;
- puissance des micro-ondes égale à 400 W;
- pression égale à 1,33 kPa (10 Torr) ;
- température égale à 600°C ;
- durée du dépôt égale à 7 heures.

On obtient ainsi une pièce en alliage TA6V dont les caractéristiques n'ont pas été changées, revêtue d'une part de sous-couches intermédiaires dont une couche réfractaire en nitrure de titane formant une barrière de diffusion pour le carbone, et d'autre part d'une couche externe de diamant ayant une épaisseur de 1,5 µm (1,5 micron) adhérant au nitrure de titane par l'intermédiaire d'une couche de carbure de titane et d'une couche sous-jacente de carbonitrure de titane.

Par ailleurs, les contraintes mesurées dans la couche de diamant après refroidissement sont sensiblement de 5 GPa et le coefficient de frottement est sensiblement inférieur à 0,1.

### Exemple 5 :

Un dépôt de diamant est réalisé sur un alliage TA6V revêtu préalablement par PVD d'une couche réfractaire en niobium de 0,5 µm (0,5 micron) d'épaisseur puis d'une couche de titane de 3 µm (3 microns) d'épaisseur.

Le dépôt de diamant est effectué au moyen du dispositif de la figure 1 selon deux étapes successives qui peuvent être ou non séparées par un retour à la température ambiante.

Dans une première étape, une couche de carbone d'accrochage pour le diamant est effectuée dans les conditions suivantes :
- débit d'hydrogène égal à 200 cm³/mn ;
- débit de méthane égal à 12 cm³/mn ;
- puissance des micro-ondes égale à 400 W;
- pression égale à 0,33 kPa;
- température égale à 600°C ;
- durée du dépôt égale à 3 heures.

Dans une deuxième étape, la pièce est revêtue d'une couche de diamant polycristallin dans les conditions suivantes :
- débit d'hydrogène égal à 180 cm³/mn ;
- débit de monoxyde de carbone égal à 15 cm³/mn ;
- puissance des micro-ondes égale à 400 W;
- pression égale à 1,33 kPa ;
- température égale à 600°C ;
- durée du dépôt égale à 7 heures.

On obtient ainsi une pièce en alliage TA6V, dont la structure n'a pas été changée, revêtue d'une part de sous-couches intermédiaires dont la couche de niobium constitue une barrière de diffusion pour le carbone, et d'autre part d'une couche externe de diamant d'épaisseur 1,5 µm (1,5 micron) adhérant au titane par l'intermédiaire d'une couche de carbure de titane.

Par ailleurs, les contraintes mesurées dans la couche de diamant sont environ de 5 GPa et le coefficient de frottement est inférieur à 0,1.

### Exemple 6 :

Un dépôt de diamant est réalisé sur un acier de type 30CD12 (de composition environ 0,30% C, 0,55% Mn, 0,25% Si, 3% Cr, 0,40% Mo) qui a été revêtu préalablement par PVD d'une couche réfractaire formant barrière de diffusion en nitrure de titane de 3 µm (3 microns) d'épaisseur, d'une couche de titane, à gradient d'azote dirigée vers l'extérieur de la pièce, de 1 µm (micron) d'épaisseur et d'une couche de titane de 3 µm (3 microns) d'épaisseur.

Le dépôt de diamant est effectué dans le dispositif de la figure 1 selon deux étapes successives qui peuvent être ou non séparées par un retour à la température ambiante.

Dans une première étape, un dépôt d'une couche de carbone d'accrochage pour le diamant est effectué sur la pièce d'alliage dans les conditions suivantes :
- débit d'hydrogène égal à 200 cm³/mn ;
- débit de méthane égal à 12 cm³/mn ;
- puissance des micro-ondes égale à 400 W;
- pression égale à 0,33 kPa;
- température égale à 580°C ;
- durée du dépôt égale à 3 heures.

Dans une deuxième étape, la pièce d'alliage est revêtue d'une couche de diamant polycristallin dans les conditions suivantes :
- débit d'hydrogène égal à 400 cm³/mn ;
- débit de méthane égal à 4 cm³/mn ;
- puissance des micro-ondes égale à 400 W;
- pression égale à 1,33 kPa (10 Torr) ;
- température égale à 580°C ;
- durée du dépôt égale à 9 heures.

On obtient ainsi une pièce en acier de type 30CD12, dont la structure n'a pas été modifiée, revêtue d'une part de sous-couches intermédiaires parmi lesquelles une couche de nitrure de titane constitue une barrière de diffusion pour le carbone, et d'autre part d'une couche externe de diamant d'épaisseur 1,5 µm (1,5 micron) adhérant au titane par l'intermédiaire d'une couche de carbure de titane.

Les contraintes mesurées dans la couche de diamant après refroidissement sont de l'ordre de 6 GPa et le coefficient de frottement est inférieur à environ 0,1.

Les différents exemples de réalisation qui ont été décrits permettent d'obtenir une pièce métallique comportant une surface contenant du titane revêtue d'une couche de diamant polycristallin adhérant fortement sur la surface de la pièce grâce à un dépôt préalable d'une couche de carbone d'accrochage diffusant dans le titane en formant une couche de carbure de titane.

La figure 5 est un enregistrement en spectroscopie RAMAN représentant l'intensité d'une onde réfléchie par la pièce métallique en fonction du nombre d'onde de l'onde incidente. Cet enregistrement est obtenu à partir de la couche de carbone d'accrochage pour le diamant des pièces métalliques revêtues de diamant conformément aux exemples 1 à 6.

Les pics d'intensité situés à 1340 et 1580 cm-1 mettent en évidence le caractère graphitique du carbone déposé, le pic du diamant de faible intensité étant noyé dans la bande à 1340 cm-1.

A partir de ce spectre et compte tenu du rapport des sections efficaces de diffusion RAMAN entre le carbone non-diamant et le diamant, compris entre 50 et 75, on peut estimer que la proportion de carbone amorphe ou graphitique est supérieure à 30%.

Cette couche ce carbone d'accrochage diffuse totalement dans la couche sous-jacente comprenant du titane et n'apparaît donc plus à la fin de l'opération de dépôt de la couche de diamant. Elle permet de revêtir la pièce métallique au moyen d'une couche de diamant polycristallin à une température inférieure à 700°C.

En variante, la couche d'accrochage permet de revêtir les pièces en carbure cémenté dont les propriétés intrinsèques ne sont pas changées jusqu'à 850°C, en obtenant un meilleur accrochage de la couche de diamant. On conçoit donc que cette couche de diamant peut être déposée à des températures comprises entre 700°C et 850°C.

Comme cela a été mentionné précédemment, la couche d'accrochage permet de déposer une couche de diamant supérieure à 1 µm (1 micron) d'épaisseur en évitant d'une part que le diamant ne s'écaille lors du retour à la température ambiante et d'autre part une modification de l'alliage entrant dans la constitution de la pièce métallique à revêtir de diamant.

## Revendications

1. Procédé de fabrication d'une pièce métallique revêtue d'une couche (24; 36; 50) de diamant polycristallin, caractérisé en ce qu'il comporte les étapes consistant à :
- fabriquer un substrat métallique (26;30;42) comprenant une surface à revêtir dont le constituant principal est le titane;
- déposer dans une première étape sur la surface à revêtir une couche de carbone d'accrochage du diamant comportant au moins 10% de carbone graphitique ou amorphe et destinée à diffuser entièrement dans la surface à revêtir pendant une deuxième étape; et
- déposer dans la deuxième étape sur la couche d'accrochage le revêtement de diamant (24;36;50).

2. Procédé selon la revendication 1, caractérisé en ce que l'on fabrique le substrat en titane ou en alliage de titane.

3. Procédé selon la revendication 1, caractérisé en ce qu'au cours de l'étape de fabrication du substrat métallique, on dépose sur une masse métallique une couche à revêtir (34;48) dont le constituant principal est le titane.

4. Procédé selon la revendication 3, caractérisé en ce qu'au cours de la fabrication du substrat métallique (26;30;42) on effectue un décapage ionique de la masse métallique, de manière à augmenter l'adhésion de la couche de carbone d'accrochage sur la surface à revêtir.

5. Procédé selon l'une des revendications 3 et 4, caractérisé en ce que l'on dépose sur la masse métallique, préalablement au dépôt de la couche à revêtir (34;48), une couche réfractaire, destinée à former une barrière pour la diffusion du carbone dans le substrat métallique (30;42).

6. Procédé selon l'une quelconque des revendications 3 à 5, caractérisé en ce que la masse métallique (26;30;42) est constitué de titane ou d'alliage de titane.

7. Procédé selon l'une quelconque des revendications 3 à 5, caractérisé en ce que la masse métallique (26;30;42) est constituée d'acier ou de carbure cémenté.

8. Procédé selon la revendication 7, caractérisé en ce que la masse métallique (30;42) étant constituée de carbure cémenté, elle est revêtue d'une couche de carbure de titane préalablement au dépôt de la couche réfractaire (32;40) en vue d'augmenter l'adhésion de celle-ci sur la masse métallique (30;42).

9. Procédé selon l'une quelconque des revendications 5 ou 8, caractérisé en ce que la couche réfractaire (32;40) est constituée d'un matériau choisi parmi le groupe constitué par le nitrure de titane, le nitrure de vanadium, le niobium, le tungstène, le tantale et le molybdène, ou d'un alliage comportant un élément choisi parmi ce groupe.

10. Procédé selon la revendication 9, caractérisé en ce que la couche réfractaire (40) étant constituée de nitrure de titane, elle est revêtue d'une deuxième couche d'accrochage (46) comportant de l'azote et du titane avec une concentration en azote décroissante en direction de la couche à revêtir (48) en vue d'augmenter l'adhésion de celle-ci sur la couche réfractaire (40).

11. Procédé selon l'une quelconque des revendications 1 à 10, caractérisé en ce que les étapes de dépôt de la couche d'accrochage et du revêtement de diamant (24;36;50) sont réalisées à une température comprise entre 400°C et 700°C.

12. Procédé selon la revendication 7, caractérisé en ce que la masse métallique étant constituée de carbure cémenté, les étapes de dépôt de la couche d'accrochage et du revêtement de diamant (24;36;50) sont réalisées à des températures respectivement comprises entre 400°C et 700°C et entre 700°C et 850°C.

## Patentansprüche

1. Fertigungsverfahren eines mit einer polykristallinen Diamantschicht (24;36;50) verkleideten Metallteils, dadurch gekennzeichnet, daß er Etappen umfaßt, welche darin bestehen:
- ein Metallsubstrat (26;30;42) mit einer zu verkleidenden Oberfläche, deren wesentlicher Bestandteil Titan ist, anzufertigen;
- in einer ersten Etappe eine Kohlenstoffschicht für das Haften der Diamantschicht, welche mindestens 10% Graphit- oder amorphen Kohlenstoff enthält und in einer zweiten Etappe zur vollständigen Diffusion in der zu verkleidenden Oberfläche bestimmt ist, auf die zu verkleidende Oberfläche aufzutragen; und
- in der zweiten Etappe die Diamantverkleidung (24;36;50) auf die Haftschicht aufzutragen.

2. Verfahren gemäß Patentanspruch 1, dadurch gekennzeichnet, daß man das Titan- oder Titanlegierungssubstrat anfertigt.

3. Verfahren gemäß Patentanspruch 1, dadurch gekennzeichnet, daß man während der Etappe der Anfertigung des Metallsubstrats eine zu verkleidende Schicht (34;48), deren wesentlicher Bestandteil Titan ist, auf eine Metallmasse aufträgt.

4. Verfahren gemäß Patentanspruch 3, dadurch gekennzeichnet, daß man während der Anfertigung des Metallsubstrats (26;30;42) ein ionisches Beizen der Metallmasse durchführt, um das Haftvermögen der Kohlenstoff-Haftschicht auf der zu verkleidenden Oberfläche zu erhöhen.

5. Verfahren gemäß einem der Patentansprüche 3 und 4, dadurch gekennzeichnet, daß man vor Anbringen der zu verkleidenden Schicht (34;48) eine feuerfeste Schicht als Schranke für die Kohlenstoffdifusion im Metallsubstrat (30,42) auf die Metallmasse aufträgt.

6. Verfahren gemäß irgendeinem der Patentansprüche 3 bis 5, dadurch gekennzeichnet, daß die Metallmasse (26;30;42) aus Titan oder einer Titanlegierung besteht.

7. Verfahren gemäß irgendeinem der Patentansprüche 3 bis 5, dadurch gekennzeichnet, daß die Metallmasse (26;30;42) aus Stahl oder einsatzgehärtetem Carbid besteht.

8. Verfahren gemäß Patentanspruch 7, dadurch gekennzeichnet, daß die Metallmasse (30;42) aus einsatzgehärtetem Carbid besteht; diese wird vor Auftragen der feuerfesten Schicht (32;40) zur Erhöhung ihres Haftvermögens auf der Metallmasse (30,42) mit einer Titancarbid-Schicht verkleidet.

9. Verfahren gemäß irgendeinem der Patentansprüche 5 bis 8, dadurch gekennzeichnet, daß die feuerfeste Schicht (32;40) aus einem aus der vom Titannitrid, Vanadiumnitrid, Niobium, Tungsten, Tantal und Molybdän gebildeten Gruppe gewählten Material, oder aus einer Legierung, welche ein innerhalb dieser Gruppe gewähltes Element enthält, besteht.

10. Verfahren gemäß Patentanspruch 9, dadurch gekennzeichnet, daß die feuerfeste Schicht (40) aus Titannitrid besteht, diese wird mit einer zweiten Haftschicht (46), welche Stickstoff und Titan enthält, wobei die Stickstoffkonzentration in Richtung der zu verkleidenden Schicht (48) abnimmt, um deren Haftvermögen auf der feuerfesten Schicht (40) zu erhöhen, verkleidet.

11. Verfahren gemäß irgendeinem der Patentansprüche 1 bis 10, dadurch gekennzeichnet, daß die Etappen des Auftragens der Haftschicht und der Diamantverkleidung (24;36;50) bei einer Temperatur zwischen 400° C und 700° C ausgeführt werden.

12. Verfahren gemäß Patentanspruch 7, dadurch gekennzeichnet, daß die Metallmasse aus einsatzgehärtetem Carbid besteht, wobei die Etappen des Auftragens der Haftschicht und der Diamantverkleidung (24;36;50) bei Temperaturen jeweils zwischen 400° C und 700° C und zwischen 700° C und 850° C ausgeführt werden.

## Claims

1. A process for manufacturing a metal part coated with a layer ( 24, 36, 50 ) of polycrystalline diamond, characterised in that it comprises the steps consisting in the following :
- manufacturing a metal substrate ( 26, 30, 42 ) comprising a surface to be coated, the principal constituent of which being titanium ;
- in a first step, depositing on the surface to be coated a carbon layer for diamond bonding comprising at least 10 % of graphitic or non crystalline carbon and intended to be totally diffused in the surface to be coated during a second step ; and
- depositing the diamond coating ( 24, 36, 50 ) on the bonding layer during the second step.

2. A process according to claim 1, characterised in that the substrate is made of titanium or titanium alloy.

3. A process according to claim 1, characterised in that during the manufacturing phase of the metal substrate, a layer ( 34, 48 ) to be coated, the main constituent of which is titanium, is deposited on a metal mass.

4. A process according to claim 3, characterised in that during the manufacturing of the metal substrate ( 26, 30, 42 ) an ionic pickling of the metal mass is performed in order to increase the adherence of the bonding carbon layer on the surface to be coated.

5. A process according to any of claims 3 and 4, characterised in that on the metal mass, prior to the deposit of the layer ( 34, 48 ) to be coated, a refractory layer is deposited, the purpose of the latter consisting in forming a barrier for the carbon diffusion in the metal substrate (30, 42).

6. A process according to any of claims 3 to 5, characterised in that - the metal mass ( 26, 30, 42 ) is composed of titanium or titanium alloy.

7. A process according to any of claims 3 to 5, characterised in that the metal mass ( 26, 30, 42 ) is composed of steel or cemented carbide.

8. A process according to claim 7, characterised in that the metal mass 30, 42 being composed of cemented carbide, is coated with a layer of titanium carbide, prior to the deposit of the refractory layer ( 32, 40 ), in order to increase the adherence of the latter onto the metal mass ( 30, 42 ).

9. A process according to any of claims 5 or 8, characterised in that the refractory layer ( 32, 40 ) is composed of a material chosen from the group comprised of titanium nitride, vanadium nitride, niobium, tantalum, tungsten and molybdenum, or an alloy including an element chosen from this group.

10. A process according to claim 9, characterised in that the refractory layer ( 40 ) being made of titanium nitride, is coated with a second bonding layer ( 46 ) comprising nitrogen and titanium with a decreasing nitrogen concentration towards the layer to be coated in order to increase the adherence of the latter onto the refractory layer ( 40 )

11. A process according to any of claims 1 to 10, characterised in that the steps of bonding layer depositing and diamond coating ( 24, 36, 50 ) are performed at a temperature ranging between 400° C and 700° C.

12. A process according to claim 7, characterised in that the metal mass being made of cemented carbide, the steps of bonding layer depositing and diamond coating ( 24, 36, 50 ) are performed, respectively, at temperatures ranging between 400° C and 700° C and between 700° C and 850° C.
